# EUROPÄISCHE PATENTSCHRIFT

(11) **EP 3 159 708 B1**
(45) Veröffentlichungstag und Bekanntmachung des Hinweises auf die Patenterteilung: **04.05.2022**
(21) Anmeldenummer: 15190361.4
(22) Anmeldetag: 19.10.2015
(51) Int. Cl.: G01R 31/392

(54) **VERFAHREN ZUM BESTIMMEN EINES ALTERUNGSZUSTANDES EINER BATTERIE, VERFAHREN ZUM STEUERN EINER BATTERIE UND BETRIEBSVORRICHTUNG**
METHOD FOR DETERMINING AN AGEING CONDITION OF A BATTERY, METHOD FOR CONTROLLING A BATTERY AND OPERATING DEVICE
PROCEDE DE DETERMINATION D'UN ETAT DE VIEILLISSEMENT D'UNE BATTERIE, PROCEDE DE COMMANDE D'UNE BATTERIE ET DISPOSITIF D'ACTIONNEMENT

(43) Veröffentlichungstag der Anmeldung: 26.04.2017
(73) Patentinhaber: Robert Bosch GmbH, 70442 Stuttgart (DE); GS Yuasa International Ltd., Kisshoin, Minami-ku, Kyoto-shi, Kyoto 601-8520 (JP)
(72) Erfinder: BECKER, Jens, 67071 Ludwigshafen Am Rhein (DE); LANGE, Ulrich, 72631 Aichtal (DE)
(74) Vertreter: Isarpatent

(56) Entgegenhaltungen:
- DE-A1-102013 206 188
- US-A1- 2012 105 068
- US-A1- 2012 176 092
- US-A1- 2015 066 406
- US-A1- 2015 147 614

## Beschreibung

### Stand der Technik

Die vorliegende Erfindung betrifft ein Verfahren zum Bestimmen eines Alterungszustandes einer Batterie, insbesondere einer Lithiumionenbatterie, ein Verfahren zum Steuern einer Batterie sowie eine Betriebsvorrichtung. Die vorliegende Erfindung betrifft insbesondere auch ein Verfahren zum Steuern des Ladens, Entladens und/oder Betriebes einer Batterie und insbesondere einer Lithiumionenbatterie sowie ein Fahrzeug.

Bei der Verwendung elektrischer Betriebsvorrichtungen werden häufig Batterien eingesetzt, um ein Betriebsmittel der Betriebsvorrichtung, zum Beispiel einen Motor oder dergleichen, mit elektrischer Energie zu versorgen und gegebenenfalls in Betrieb zu setzen. Bei derartigen Batterien kann es sich um primäre Batterien oder auch um Sekundärbatterien handeln, zum Beispiel um Akkumulatoren oder dergleichen, welche wieder aufladbar sind. Für einen optimalen Betrieb, aber auch für die Pflege, Wiederaufladung und Regeneration derartiger Batterien können Kenntnisse in Bezug auf einen Alterungszustand der Batterie, der auch durch Ladungsinhomogenitäten widergespiegelt wird, hilfreich sein.

Bisherige Zustandserkennungen ermöglichen bei Batterien nur die Messung eines mittleren Ladezustandes einer gesamten Batteriezelle. Inhomogene Ladungszustände, wie sie bei gealterten Batteriezellen auftreten können, werden dabei nicht berücksichtigt. Insbesondere können bei bestimmten Elektrodenkonfigurationen Inhomogenitäten auftreten und es kann sich zum Beispiel ein Anodenpotential innerhalb eines weiten Ladungsbereiches kaum ändern, so dass sich die Inhomogenitäten an der Anode sich nicht ausgleichen können. Dies kann dazu führen, dass an bestimmte Stellen auf Grund einer partiellen und lokalen Überladung eine sogenannte Plattierung auftritt, also eine Abscheidung einer metallischen Komponente.

Die US 2012/0176092 A1 offenbart eine Einrichtung zum Detektieren der Kapazität in Lithium-Ionen-Batterien vom wiederaufladbaren Typ, wobei ein Wendepunkt in einem Batterieladezustand ermittelt wird. Der Wendepunkt zeigt dabei eine Änderung in der Korrelation zwischen der Batteriespannung und dem Ladungszustand der Batterie an.

Die US 2015/147614 A1 beschreibt den Spannungsschutz und die Zustandsüberwachung bei Batterien unter Verwendung von Referenzelektroden, wobei eine Echtzeitüberwachung von Elektrodenspannungen zugrundegelegt wird.

Die DE 10 2013 206 188 A1 beschreibt eine Batterieüberwachung auf der Grundlage einer Echtzeitauswertung eines Differentials.

Die US 2012/105068 A1 beschreibt ein Überwachungsverfahren für eine Batterie, bei welchem ein Vergleich mit einer zugrundegelegten Modellladekurve verwendet wird.

Die US 2015/066406 A1 beschreibt ein Batterieüberwachungsverfahren auf der Grundlage einer Parameteranpassung an ein Batteriemodell.

Plattierungen sind für den Betrieb einer Batterieanordnung schädlich und können zu Kapazitätseinbußen oder gar zu Batteriedefekten und deren Ausfall führen. Derartige Zustände können aber mit bisherigen Messverfahren nicht detektiert werden.

### Offenbarung der Erfindung

Das erfindungsgemäße Verfahren mit den Merkmalen des Anspruchs 1 weist demgegenüber den Vorteil auf, dass ein Alterungszustand einer Batterie besonders zuverlässig bestimmt und diese Erkenntnis dann der weiteren Verwendung und dem weiteren Betrieb der Batterie zu Grunde gelegt werden kann. Dies wird erfindungsgemäß mit den Merkmalen des Anspruches 1 erreicht.

Ein Kernaspekt der vorliegenden Erfindung beruht also auf der Abhängigkeit signifikanter Teilabschnitte oder Punkte einer Batteriekennlinie vom Zustand der Batterie und insbesondere von deren Alter. Sind entsprechend signifikante Teilabschnitte oder Punkte einer Batteriekennlinie einer Batterie im ursprünglichen Zustand, das heißt in einem nicht gealterten Zustand oder in einem Zustand eines definierten Alters, bekannt, so kann aus einer Änderung von Charakteristika eines oder mehrerer signifikanter Teilabschnitte oder Punkte in der Kennlinie der Batterie mit fortschreitender Zeit auf den Alterungszustand der Batterie geschlossen werden. Diese Kenntnis kann eingesetzt werden, um die Verwendung, die Pflege und den Betrieb der Batterie zu gestalten und zu steuern.

Die Kennlinie einer Batterie zum Zeitpunkt t2 kann z.B. im Betrieb durch Aufnahme einzelner Punkte dieser Kennlinie während Ruhepausen der Batterie und anschließendes Angleichen mit Hilfe eines Algorithmus erstellt werden. Diese Aufgabe kann z.B. ein Batteriemanagementsystem durchführen. Die Kennlinie einer neuen Batteriezelle ist durch Messung bekannt. Aus der Ableitung der Kennlinie kann dann - wie nachfolgend beschrieben wird - die Position und Amplitude des Peaks bestimmt werden und z.B. mit dem Peak einer neuen Kennlinie verglichen werden.

Bei einer Batteriekennlinie handelt es sich im Sinne der vorliegenden Erfindung um den funktionalen Zusammenhang einer Spannung in Abhängigkeit von einem Ladungsparameter. Bei der Spannung kann es sich um die Spannung V einer Vollzelle, um die Kathodenspannung Vc oder um die Anodenspannung Va einer Batteriezelle handeln. Der Ladungsparameter kann zum Beispiel gegeben sein durch die absolute oder relative Ladekapazität, nämlich einem SOC-Wert (SOC : State of Charge) oder um die absolute oder relative Entladekapazität, nämlich einem DOD-Wert (DOD : Depth of Discharge).

Im Zusammenhang mit dem Veränderungsmaß oder Alterungsmaß kann auch von einem Veränderungssignal oder einem Alterungszustandssignal gesprochen werden, welche jeweils repräsentativ sind für das Maß der Veränderung beziehungsweise für das Maß der Alterung eines signifikanten Teilabschnittes oder Punktes in einem Abschnitt einer Kennlinie der Batterie beziehungsweise für einen Alterungszustand der Batterie insgesamt.

Die Unteransprüche zeigen bevorzugte Weiterbildungen der Erfindung.

Zur Charakterisierung des Alterungszustandes einer Batterie kann das repräsentative Alterungsmaß oder Alterungssignal zum Beispiel durch ein Alterungszustandssignal beschrieben werden. Das Alterungsmaß oder das Alterungszustandssignal können repräsentativ sein für oder abgeleitet sein von einer Änderung in der Lage oder Position eines oder mehrerer entsprechender signifikanter Teilabschnitte oder Punkte einer Kennlinie der Batterie. Zusätzlich oder alternativ können das Alterungsmaß oder das Alterungszustandssignal repräsentativ sein für geometrische Charakteristika eines oder mehrerer signifikanter Teilabschnitte oder Punkte einer Kennlinie der Batterie.

Besonders geeignet ist das erfindungsgemäße Verfahren, wenn gemäß einer bevorzugten Ausführungsform der erste Zeitpunkt t1 unmittelbar vor, auf oder unmittelbar nach einem Zeitpunkt eines Beginns eines Betriebes, insbesondere eines Erstbetriebes der Batterie liegt und/oder der zweite, spätere Zeitpunkt t2 in oder nach einem Betrieb der Batterie liegt. Dabei kann der spätere Zeitpunkt t2 z.B. ein gleitender Parameter sein, welcher der aktuellen Betriebszeit der Batterie entspricht.

Alternativ oder zusätzlich kann der zweite Zeitpunkt t2 jeweils einer Liste von Zeitpunkten oder einem Algorithmus, welcher entsprechende Zeitpunkte festlegt, entnommen werden.

Zum Beispiel bietet es sich an, als zweiten Zeitpunkt t2 jeweils Zeitpunkte festzusetzen, bei welchen die zu Grunde liegende Betriebsvorrichtung sich in einem Leerlaufzustand oder einem angehaltenen Zustand befindet. Bei einem Elektrofahrzeug entspräche dies zum Beispiel einem Zustand, bei welchem das Fahrzeug aus einer Bewegung heraus gestoppt wurde und nun ruht.

Es sind aber auch andere Szenarien denkbar, um Zeitpunkte zur Bestimmung des Alterungszustandes einer verwendeten Batterie zu erheben.

Grundsätzlich bieten sich sämtliche signifikante Aspekte einer Batteriekennlinie zur Ableitung eines Veränderungsmaßes oder -signales und somit eines Alterungszustandes an, deren Eigenschaften sich mit fortlaufender Zeit und somit dem wachsenden Alter der zu Grunde liegenden Batterie ändern.

Besonders vorteilhaft gestaltet sich das erfindungsgemäße Verfahren dann, wenn der signifikante Teilabschnitt oder Punkt ein Teil einer Stufe, eines Peaks und/oder Flanke in der Kennlinie der Batterie und/oder in einer - insbesondere durch Differentiation oder Integration gewonnenen - Ableitung der Kennlinie der Batterie ist.

Beim Bewerten einer Batteriekennlinie sind verschiedene Messgrößen auswertbar. Gemäß einer anderen Ausführungsform des erfindungsgemäßen Verfahrens ist es vorgesehen, dass die Kennlinie der Batterie eine Kennlinie einer Vollzelle der Batterie, eine Kennlinie einer Anode der Batterie und/oder eine Kennlinie einer Kathode der Batterie ist oder aufweist und/oder repräsentativ ist für einen Verlauf einer Leerlaufspannung der Batterie.

Dabei ist es von besonderem Vorteil, wenn das Veränderungsmaß repräsentativ ist für eine Änderung (i) einer Position, (ii) einer Ausdehnung, (iii) einer Form und/oder (iv) einer Amplitude des signifikanten Teilabschnittes oder Punktes in dem Abschnitt der Kennlinie der Batterie.

Besonders genau gestaltete sich das erfindungsgemäße Verfahren, wenn gemäß einer bevorzugten Ausgestaltungsform der Schritt (C) des Erfassens des entsprechenden signifikanten Teilabschnittes oder Punktes zum zweiten Zeitpunkt t2 ein Erfassen einer entsprechenden Kennlinie der Batterie zum zweiten Zeitpunkt t2 aufweist.

Ein besonders hohes Maß an Genauigkeit beim Bestimmen eines signifikanten Teilabschnittes oder Punktes einer Kennlinie ergibt sich bei einer bevorzugten Ausführungsform, bei welcher ein signifikanter Teilabschnitt oder Punkt in einer der Kennlinien der Vollzelle, der Anode und der Kathode der Batterie bestimmt und durch Auffinden in mindestens einer anderen der Kennlinien der Vollzelle, der Anode und der Kathode verifiziert wird.

Es bieten sich verschiedene Maße an, um die Qualität der Batterie und/oder den Zustand und das Alter der Batterie anzuzeigen. So ist es bei einer bevorzugten Ausführungsform des erfindungsgemäßen Verfahrens vorgesehen, dass - wenn (i) eine Verschiebung eines signifikanten Teilabschnittes oder Punktes in der Kennlinie der Batterie und/oder in einer Ableitung der Kennlinie der Batterie ermittelt wird und wenn (ii) wenn die Verschiebung insbesondere ein vorgegebenes Maß überschreitet - angezeigt wird, dass die Batterie ohne Inhomogenität im Ladezustand und/oder ohne Metallplattierung an einer der Elektroden und insbesondere der Anode gealtert ist.

Dabei ist es von besonderem Vorteil, wenn der Alterungszustand einer verwendeten Batterie in Bezug gesetzt wird mit möglichen Inhomogenitäten in Folge von Metallplattierungen an einer Elektrode. Gemäß einer anderen bevorzugten Ausführungsform des erfindungsgemäßen Verfahrens wird daher-wenn (iii) eine Verbreiterung eines signifikanten Teilabschnittes und/oder eine Absenkung der Amplitude eines signifikanten Teilabschnittes oder Punktes in der Kennlinie der Batterie und/oder in einer Ableitung der Kennlinie der Batterie ermittelt wird und wenn (iv) insbesondere die Verbreiterung und/oder die Absenkung der Amplitude ein vorgegebenes Maß überschreiten und insbesondere der entsprechende signifikante Teilabschnitt oder Punkt in der Kennlinie der Batterie und/oder in einer Ableitung der Kennlinie der Batterie zum zweiten Zeitpunkt t2 nicht bestimmt werden können - angezeigt, dass die Batterie mit Inhomogenität im Ladezustand und/oder mit Metallplattierung an einer der Elektroden und insbesondere der Anode gealtert ist.

Ferner betrifft die vorliegende Erfindung ein Verfahren zum Steuern einer Batterie und insbesondere des Ladens, Entladens und/oder Betriebes einer Batterie, insbesondere einer Lithiumionenbatterie, bei welchem der Alterungszustand der Batterie mit einem erfindungsgemäßen Verfahren durch Erzeugen eines Alterungsmaßes der Batterie bestimmt und ein Laden, ein Entladen und/oder ein Betrieb der Batterie auf der Grundlage des Alterungsmaßes der Batterie gesteuert wird.

Die vorliegende Erfindung betrifft des Weiteren eine Betriebsvorrichtung und insbesondere ein Fahrzeug mit einem Betriebsmittel zum Ausführen eines Betriebsvorganges, einer Batterie zum Versorgen des Betriebsmittels mit elektrischer Energie und einer Steuereinheit zum Steuern des Betriebsmittels und insbesondere des Versorgens des Betriebsmittels und/oder der Batterie mit elektrischer Energie, wobei die Steuereinheit eingerichtet ist, ein erfindungsgemäßes Verfahren auszuführen.

### Kurzbeschreibung der Figuren

Unter Bezugnahme auf die beigefügten Figuren werden Ausführungsformen der Erfindung im Detail beschrieben.
- Figur 1: zeigt in Form eines schematischen Blockdiagramms eine Ausführungsform einer erfindungsgemäßen Betriebsvorrichtung.
- Figuren 2 bis 7: zeigen in Form von Graphen in schematischer Form Batteriekennlinien und Details zur Auswertung signifikanter Teilabschnitte oder Punkte aus den Kennlinien.
- Figuren 8 bis 13: zeigen in Form von Graphen aus konkreten Batterieanordnungen gewonnene Kennlinien und Details zu deren Bewertung im Hinblick auf signifikante Teilabschnitte oder Punkte aus Batteriekennlinien zur Bestimmung eines Alterungszustandes der zu Grunde liegenden Batterie.

### Bevorzugte Ausführungsformen der Erfindung

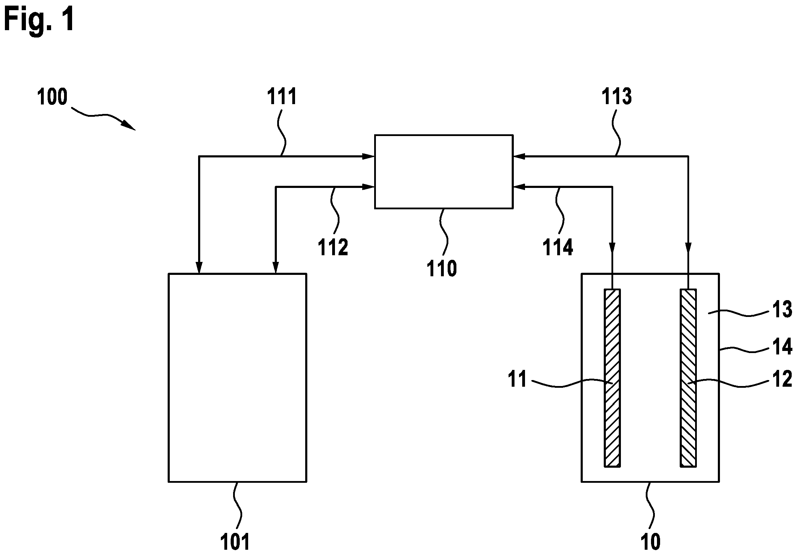

Nachfolgend werden unter Bezugnahme auf die Figuren 1 bis 13 Ausführungsbeispiele der Erfindung im Detail beschrieben. Gleiche und äquivalente sowie gleich oder äquivalent wirkende Elemente und Komponenten werden mit denselben Bezugszeichen bezeichnet. Nicht in jedem Fall ihres Auftretens wird die Detailbeschreibung der bezeichneten Elemente und Komponenten wiedergegeben.

Die dargestellten Merkmale und weiteren Eigenschaften können in beliebiger Form von einander isoliert und beliebig miteinander kombiniert werden, ohne den Kern der Erfindung zu verlassen.

Figur 1 zeigt in Form eines schematischen Blockdiagramms einer Ausführungsform einer erfindungsgemäßen Betriebsvorrichtung 100.

Die Betriebsvorrichtung 100 weist ein Betriebsmittel 101 auf. Dieses kann zum Beispiel gebildet werden von einem Motor oder einer Kombination von Motoren, zum Beispiel im Rahmen eines Hybridantriebes. Des Weiteren ist eine Batterie 10 vorgesehen, welche zum Versorgen des Betriebsmittels 101 mit elektrischer Energie ausgebildet ist. Ferner weist die Betriebsvorrichtung 100 eine Steuereinheit 110 auf. Die Steuereinheit 110 ist eingerichtet zum Steuern des Betriebsmittels 101 und insbesondere des Versorgens des Betriebsmittels 101 und/oder der Batterie 10 mit elektrischer Energie. Die Steuereinheit 110 dient also insbesondere dazu, den Betrieb und die Verwendung der Batterie 10 zu steuern. Insbesondere ist daran gedacht, dass Entladen, nämlich beim Versorgen des Betriebsmittels 101 mit Energie, und das Wiederaufladen der Batterie 10 in geeigneter Weise und in Abhängigkeit vom Alterungszustand der Batterie 10 zu steuern.

Die Batterie 10 weist im Inneren eines Gehäuses 14 eine Elektrodenanordnung mit Elektroden 11, 12, nämlich einer Anode 11 und einer Kathode 12 auf. Die Anode 11 und die Kathode 12 sind in einem Elektrolyten 13 eingebettet. Anode 11 und Kathode 12 sind über Steuer- und Messleitungen 113 und 114 mit der Steuereinheit 110 verbunden. Über ein weiteres Paar von Mess- und Steuerleitungen 111 und 112 ist auch das Betriebsmittel 101 mit der Steuereinheit 110 verbunden.

Die Steuereinheit 110 ist erfindungsgemäß insbesondere dazu ausgebildet, ein einfindungsgemäßes Verfahren zum Bestimmen eines Alterungszustandes der Batterie 10 auszuführen und insbesondere den bestimmten Alterungszustand dem Betrieb der Batterie 10 zu Grunde zu legen, insbesondere um die Effektivität des Betriebes der Batterie 10 und/oder deren Lebensdauer zu steigern.

Bei der Betriebsvorrichtung 101 kann es sich zum Beispiel um ein Fahrzeug handeln. Die Batterie 10 selbst kann zum Beispiel eine Lithiumionenbatterie sein.

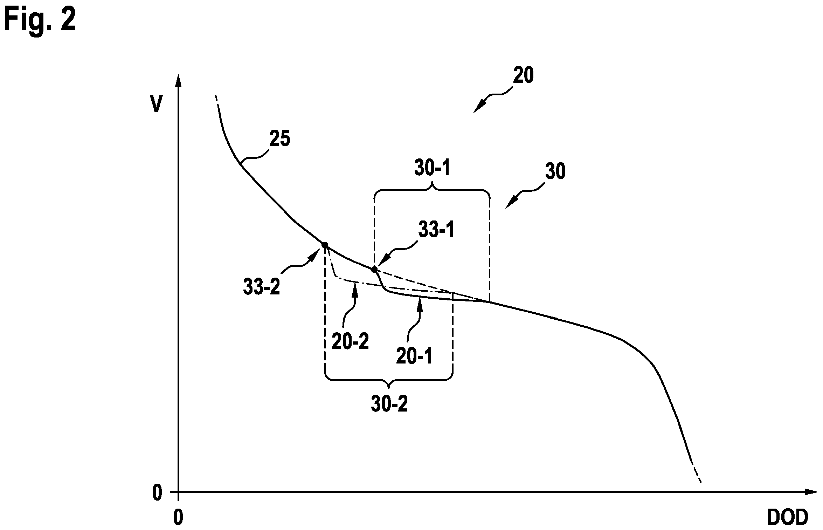

Figur 2 zeigt in schematischer Form nach Art eines Graphen eine Kennlinie 20 einer Batterie 10. Im Graphen der Figur 2 sind auf der Abszisse Werte einer Entladekapazität, also DOD-Werte (DOD : Depth of Discharge) absolut oder vorzugsweise normiert aufgetragen. An der Ordinate des Graphen der Figur 2 sind Spannungswerte aufgetragen, hier die Werte der Spannung V der Vollzelle einer Batterie 10.

Aus dem monoton abfallenden Verlauf der Kennlinie 20 im Graphen der Figur 2 erkennt man, dass die Spannung V der Vollzelle der Batterie 10 mit steigender Entladung der Batterie 10 absinkt.

Experimentelle Ergebnisse der Erfinder haben gezeigt, dass in einem bestimmten Abschnitt 25 der Kennlinie 20 ein signifikanter Teilabschnitt 30 und insbesondere ein signifikanter Punkt 33 vorliegen, deren Eigenschaften vom Alter der Batterie abhängig sind.

Die durchgezogene Spur im Graphen der Figur 2 zeigt den signifikanten Teilabschnitt 30 als signifikanten Teilabschnitt 30-1 zu einem ersten Zeitpunkts t1 in Form einer Stufe. Als signifikanter Punkt 33 der Kennlinie 20 kann zum Beispiel der Anfangspunkt der Stufe als signifikanter Teilabschnitt 30-1 aufgefasst werden, dieser ist in der durchgezogenen Spur mit dem Bezugszeichen 33-1, also als signifikanter Punkt 33 der Kennlinie 20 zum Zeitpunkt t1 bezeichnet.

Die Erfinder haben des Weiteren festgestellt, dass sich mit zunehmendem Alter der Batterie 10 Position, Ausmaß und/oder Form oder Gestalt des signifikanten Teilabschnittes 30, also des Teilabschnittes 33-1 zum Zeitpunkt t1, zu einem späteren Zeitpunkt t2 hin ändern können und dass diese Änderung als ein Maß für den Alterungszustand der zu Grunde liegenden Batterie 10 herangezogen werden kann.

In Bezug auf eine Stufe als signifikantem Teilabschnitt 30-1 zur durchgezogenen Spur im Graphen aus Figur 2 ist eine mögliche Verschiebung zu einem signifikanten Teilabschnitt 30-2 hin dargestellt, wobei der Anfang der verschobenen Stufe des signifikanten Teilabschnitts 30-2 zum Zeitpunkt t2 als signifikanter Punkt 33-2 zum Zeitpunkt t2 fungiert.

Die verschobene Stufe des signifikanten Teilabschnitts 30-2 zum späteren Zeitpunkt t2 ist in der Figur 2 strichpunktiert dargestellt.

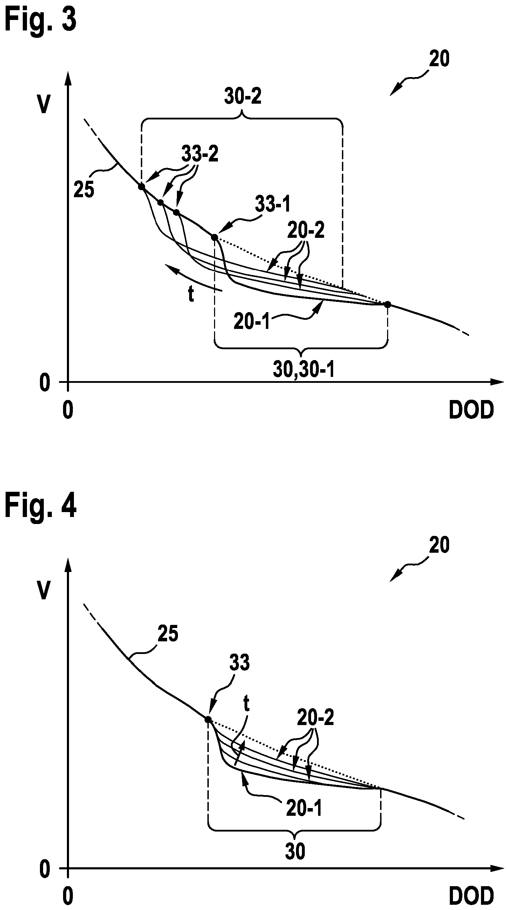

Figur 3 zeigt eine Schar von Kennlinien 20 zu verschiedenen aufeinanderfolgenden Zeitpunkten ausgehend von einem frühesten Zeitpunkt t1 und wiederum in einem Graphen. Dort ist die Zellspannung V einer Vollzelle als Funktion der Entladekapazität, also eines DOD-Wertes aufgetragen.

Mit anwachsender Zeit t, dargestellt durch den von rechts unten nach links oben verlaufenden und mit t bezeichneten Pfeil ergibt sich, dass die Stufe als signifikanter Teilabschnitt 30-1 mit voranschreitender Zeit von rechts unten nach links oben als späterer signifikanter Teilabschnitt 30-2 wandert, wobei der Anfangspunkt als signifikanter Punkt 33-1 mit fortschreitender Zeit ebenfalls entlang der Kennlinie 20 von rechts unten nach links oben verschoben wird. Eine derartige Entwicklung wird von den Erfindern in Zusammenhang gebracht mit einer Alterung einer zu Grunde liegenden Batterie 10 auf Grund von Verlust an zyklisierbarem Lithium.

Im Gegensatz dazu zeigt der Graph der Figur 4, bei welchem die Zellspannung V einer Vollzelle als Funktion der Entladekapazität, also eines DOD-Wertes aufgetragen ist, dass - hier unter Beibehaltung des signifikanten Punktes 33, nämlich des Anfangspunktes der Stufe des signifikanten Teilabschnittes 30 -die Amplitude der Stufe des signifikanten Teilabschnittes 30 mit voranschreitender Zeit, angezeigt durch den von links unten nach rechts oben verlaufenden und mit t bezeichneten Pfeil, absinkt und zum Beispiel auch verschwinden kann.

Ein derartiger Verlauf, bei welchem die Amplitude in einem signifikanten Teilabschnitt 30 mit voranschreitender Zeit absinkt und gegebenenfalls die Stufe komplett verschwindet, wird von den Erfindern in Zusammenhang gebracht mit einem Altern der zu Grunde liegenden Batterie 10 auf Grund eines zyklischen Betriebes und der Ausbildung von Inhomogenitäten mit der möglichen Folge von Metallplattierung an der Anode.

Derartige Effekte werden zum Beispiel konkret bei Lithiumionenbatterien mit Lithiumplattierungen an der Anode beobachtet.

Im Allgemeinen werden sich die in Figur 3 und 4 dargestellten Effekte an den signifikanten Teilabschnitten 30 und den signifikanten Punkten 33 überlagern. Das bedeutet, dass im Allgemeinen eine Stufe als signifikanter Teilabschnitt 33 nicht nur verschoben wird, sondern sich auch in seiner Amplitude absenkt und/oder verbreitert. Im Allgemeinen finden also eine Verschiebung, eine Verbreiterung und/oder Amplitudenabnahme des signifikanten Teilabschnittes 33 in Form einer Stufe gemeinsam statt.

Bei bevorzugten Ausführungsformen des erfindungsgemäßen Verfahrens zum Bestimmen eines Alterungszustandes einer zu Grunde liegenden Batterie 10 wird daher besonderes Augenmerk gelegt auf die Charakterisierung des signifikanten Bereiches und seines Verlaufes und seiner Änderung.

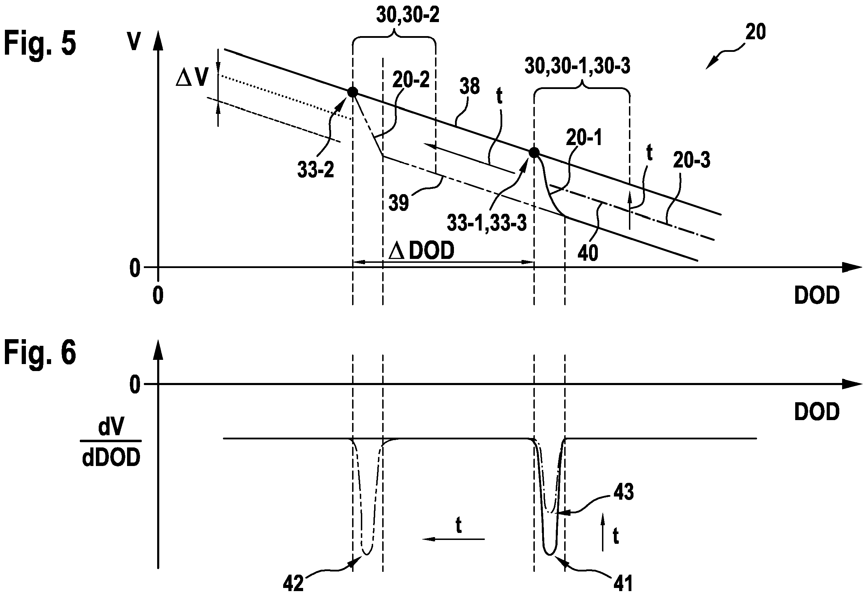

Die Figuren 5 bis 7 zeigen in schematischer Form charakteristische Aspekte einer Stufe als signifikantem Teilabschnitt 30 zu verschiedenen Zeitpunkten t1 und t2. Allgemein wird hier der signifikante Teilabschnitt mit dem Bezugszeichen 30 bezeichnet. Bei unterschiedlichen Zeitpunkten t1 und t2 wird dieser signifikante Teilabschnitt 30 zur besseren Unterscheidung auch mit den Bezugszeichen 30-1 und 30-2 bezeichnet. Analoges gilt einem signifikanten Punkt 33, der zu verschiedenen Zeitpunkten t1 und t2 zur besseren Unterscheidung mit den Bezugszeichen 33-1 beziehungsweise 33-2 bezeichnet wird.

Figur 5 zeigt zu einem ersten Zeitpunkt t1 in der durchgezogenen Kennlinie 20-1 zur Batterie 10 gemäß der Spur 38 eine Stufe als signifikanten Teilabschnitt 30-1 mit dem Startpunkt der Stufe als signifikanten Punkt 33-1.
(i) Diese Stufe ist in der Spur 39 als doppelt punktiert und gestrichelt dargestellte Kennlinie 20-2 zu einem späteren Zeitpunkt t2 um einen Wert ΔDOD entlang der Abszisse zusammen mit dem Startpunkt 33-2 zu geringeren DOD-Werten verschoben.
(ii) Alternativ ist in der Spur 40, welche eine entsprechende strichpunktiert dargestellte Kennlinie 20-3 zu einem späteren Zeitpunkt t3 zeigt, die Stufe als signifikanter Teilbereich 30-3 in seiner Amplitude bei unveränderter Lage des Startpunktes als signifikantem Punkt 33-3 abgesenkt.

In Figur 6 ist zur Analyse der signifikanten Teilabschnitte 30-1, 30-2 und 30-3 der Kennlinien 20-1, 20-2 und 20-3 die erste Ableitung der Zellspannung V der Vollzelle nach der Entladekapazität DOD dargestellt, also die Kennlinie des Zusammenhangs dV/dDOD.
(iii) Es ergibt sich, dass der Verschiebung ΔDOD der signifikanten Teilabschnitte 30-1 und 30-2 aus Figur 5 zueinander in Figur 6 einer Verschiebung ΔDOD des Peaks 41 zur ursprünglichen Kennlinie 20-1 der Spur 38 aus Figur 5 zum Peak 42 zur späteren Kennlinie 20-2 der Spur 39 aus Figur 5 entspricht.
(iv) Die Absenkung der Amplitude der Stufe im Übergang von der früheren Kennlinie 20-1 der Spur 38 aus Figur 5 zur späteren Kennlinie 20-3 der Spur 40 aus Figur 5 führt dagegen in Figur 6 bei unveränderter Lage nur zu einem Peak 43 mit geringerer Amplitude als der des Peaks 41. Es ergibt sich also aus dem Amplitudenunterschied ΔV der signifikanten Teilbereiche 30-1 und 30-3 der Kennlinien 20-1 und 20-3 im Vergleich zueinander bei der ersten Ableitung gemäß Figur 6 ein entsprechender Amplitudenunterschied zwischen den Peaks 41 und 43.

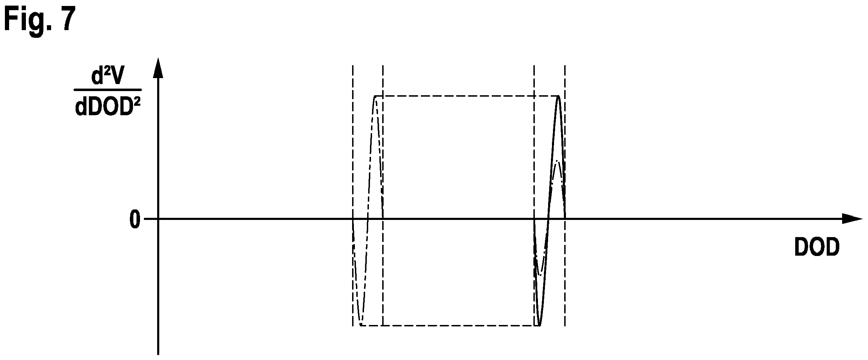

Auch die zweiten Ableitungen d²V/dDOD² gemäß Figur 7 können zur Auswertung herangezogen werden und zeigen entsprechende Verhältnisse in Bezug auf die Verschiebung ΔDOD und die Amplitudenänderung ΔV.

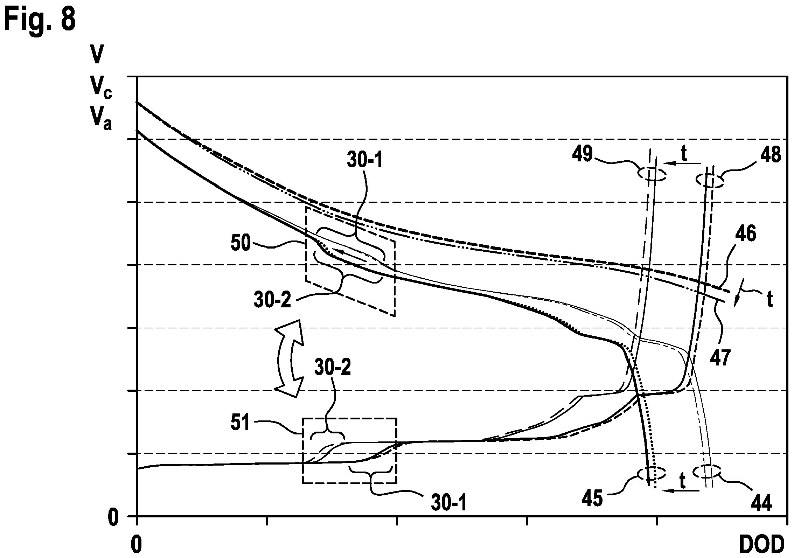

Figur 8 zeigt in Form eines Graphen Messergebnisse, die bei der Verwendung einer konkreten Lithiumionenbatterie 10 aus deren Alterungsprozess gewonnen wurden. Dabei sind verschiedene Kurvenscharen 44 bis 49 zu einer Mehrzahl von Messungen dargestellt.

Die Kurvenscharen 44 und 45 zeigen Kennlinien 20-1, 20-2 zur Spannung V einer Vollzelle einer zu Grunde liegenden Batterie 10 zu einem früheren und zu einem späteren Zeitpunkt t1 bzw. t2.

Gemäß dem Merkmalskästchen 50 ist die Stufe als signifikanter Teilabschnitt 30-1 der Kurvenschar 44 zur Kennlinie 20-1 zu einem früheren Zeitpunkt t1 zu einem späteren Zeitpunkt t2 als signifikanter Teilabschnitt 30-2 in der Kurvenschar 45 zur späteren Kennlinie 20-1 zu geringeren DOD-Werten verschoben wird. Diese Verschiebung korrespondiert mit einer entsprechenden Verschiebung der Kurvenscharen 44 und 45 insgesamt.

Die Stufen in der Kennlinie zur Spannung V der Vollzelle der Batterie 10 korrespondieren gemäß dem Merkmalskästchen 51 im Graphen der Figur 8 zu Stufen in der Kennlinie der Anodenspannung Va der Batterie 10, und zwar mit einer entsprechenden Verschiebung der signifikanten Teilabschnitte 30-1 und 30-2 in den Kurvenscharen 48 und 49 zu einem früheren und zu einem späteren Zeitpunkt t1 bzw. t2.

Das gleichzeitige Auftreten der Stufen als signifikante Teilabschnitten 30-1 und 30-2 in den Kennlinien der Spannung V der Vollzelle der Batterie 10 und in den Kennlinien der Anodenspannung Va der Batterie 10 kann als Plausibilitätskriterium zum Definieren des zu Grunde liegenden signifikanten Teilabschnitts 30 bei der Auswertung verwendet werden.

Auch die Kurvenscharen 48 und 49 zum ersten und zum späteren zweiten Zeitpunkt t1 bzw. t2 sind insgesamt zueinander verschoben.

Die Kurvenscharen 46 und 47 zeigen Kennlinien der Kathodenspannung Vc der zu Grunde liegenden Batterie 10, wobei auch hier eine leichte Verschiebung der Kurven zur Schar 46 zum früheren Zeitpunkt t1 nach unten zu den Kurven der Schar 47 zum späteren Zeitpunkt t2 vorliegt.

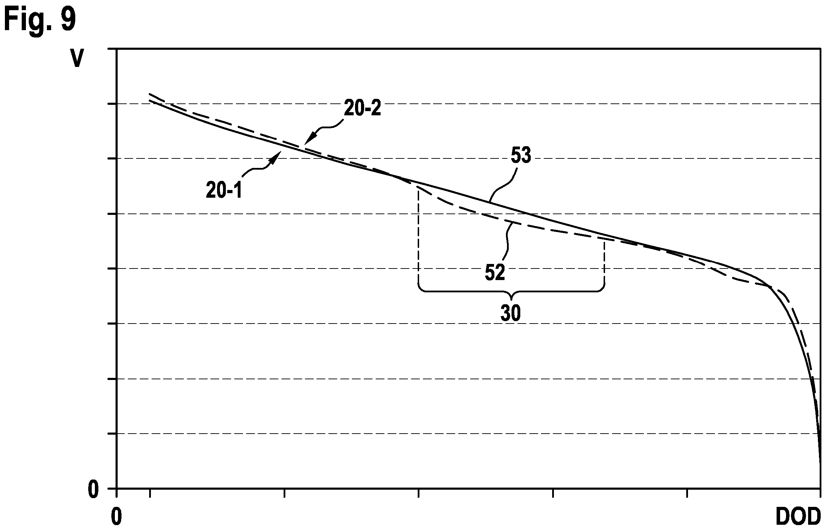

Figur 9 zeigt in Form eines Graphen zwei Kennlinien der Spannung V einer Vollzelle der zu Grunde liegenden Batterie, und zwar in der Spur 52 eine Kennlinie 20-1 einer unverbraucht zu Grunde liegenden Batterie 10 zu einem früheren Zeitpunkt t1 und in der Spur 53 eine Kennlinie 20-2 der Spannung der Vollzelle derselben Batterie 10 zu einem späteren Zeitpunkt t2 und mit Metallplattierung an der Anode auf Grund von Inhomogenitäten.

Es wird deutlich, dass die Stufe als signifikanter Teilabschnitt 30-1 der Spur 52 zum späteren Zeitpunkt t2 in der Spur 53 auf Grund der Inhomogenitäten an der Anode verschwunden ist und nicht mehr nachgewiesen werden kann. Die fehlende Nachweisbarkeit einer früher vorhandenen Stufe als signifikantem Teilabschnitt kann als ein Hinweis auf das Vorliegen einer Ladungsinhomogenität an einer der Elektroden, hier der Anode, gewertet und erfindungsgemäß ausgenutzt werden.

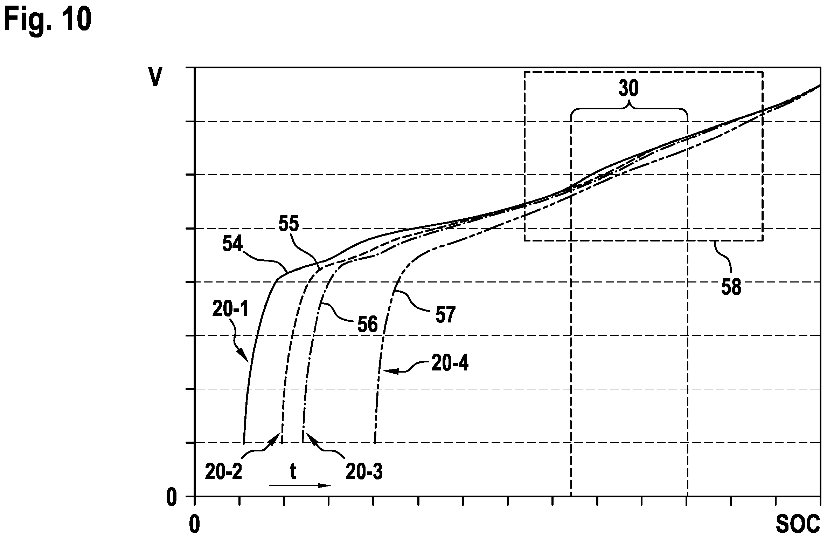

Figur 10 zeigt in Form eines Graphen in Spuren 54, 55, 56 und 57 Kennlinien 20-1 bis 20-4 der Spannung V einer Vollzelle einer zu Grunde liegenden Batterie 10 zu vier aufeinander folgenden Zeitpunkten t1 < t2 < t3 < t4. Die Reihenfolge der Messzeitpunkte t1, ..., t4 ist durch den von rechts nach links weisenden Pfeil mit der Bezeichnung t angedeutet.

Die Spannung V der Vollzelle der zu Grunde liegenden Batterie 10 ist hier als Funktion der absoluten Ladekapazität dargestellt. Das Merkmalskästchen 58 weist auf die in den Kennlinien 20-1 bis 20-4 der Spuren 54 bis 57 vorhandene Stufe 30 als signifikanten Teilabschnitt 30-1 bis 30-4 hin.

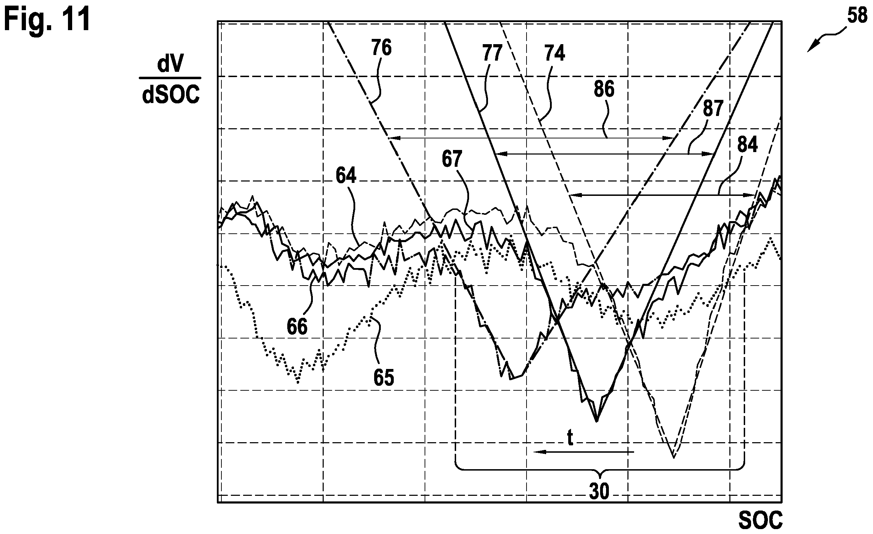

In Figur 11 wird der Bereich des Merkmalskästchens 58 mit dem signifikanten Teilabschnitt 30 in den Spuren 54 bis 57 einer genaueren Analyse unterzogen. Gemäß Figur 11 wird nämlich die erste Ableitung der Spannung V der Vollzelle der zu Grunde liegenden Batterie 10 nach den SOC-Werten gebildet. Es wird also die Kennlinie der Ableitung dV/dSOC dargestellt und zur Auswertung verwendet.

Die so gebildeten Ableitungen der Spuren 54 bis 57 sind in Figur 11 mit den Bezugszeichen 64 bis 67 bezeichnet. Im Bereich der jeweiligen Stufe als signifikantem Teilabschnitt 30 ergibt sich in jeder der Spuren 64 bis 67 gemäß den allgemeinen Darlegungen im Übergang von Figur 5 zu Figur 6 ein besonders markanter Verlauf in der Ableitung. Die jeweilige Änderung wird zur quantitativen Analyse durch eine Dreiecksfunktion 74 bis 77 mit einem entsprechenden Wert für eine Halbwertsbreite 84 bis 87 approximiert. Der mit t bezeichnete Pfeil von rechts nach links beschreibt in Figur 11 die Reihenfolge der jeweiligen Messzeitpunkte t1 bis t4.

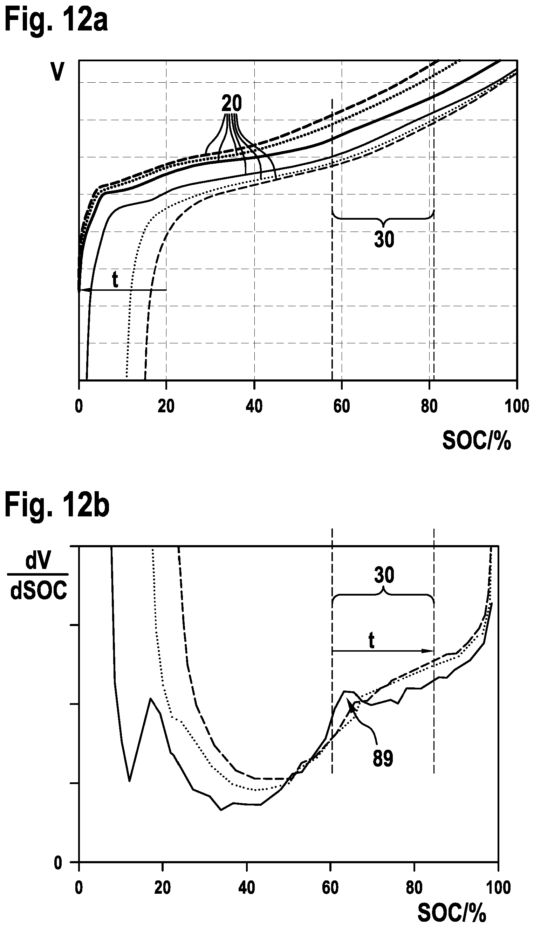

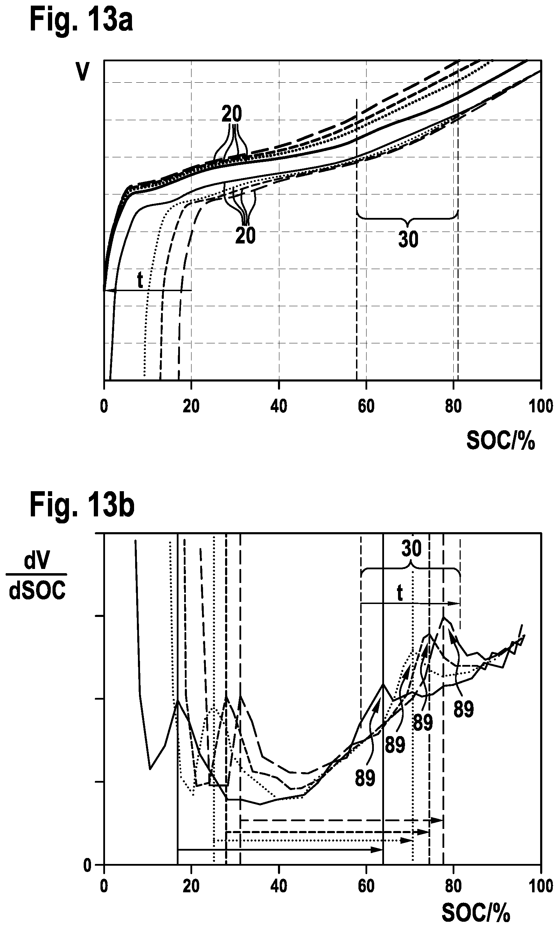

Die Figuren 12 und 13 zeigen eine zu den Figuren 10 und 11 analoge Betrachtungsweise.

In den Figuren 12(a) und 13(a) sind Scharen von Kennlinien 20 der Zellspannung V einer Vollzelle einer zu Grunde liegenden Batterie 10 als Funktion und Ladekapazität, also der SOC-Werte zu verschiedenen Zeitpunkten aufgenommen. In den Figuren 12(b) und 13(b) werden die ersten Ableitungen dV/dSOC der entsprechenden Kennlinien 20 aus den Figuren 12(a) und 13(a) gebildet.

Der signifikante Teilabschnitt 30 befindet sich in den Figuren 12(a) bis 13(b) im Bereich zwischen 60 % und 80 % der SOC-Werte. Dort ist eine leichte Stufe zu erkennen. Diese Stufe als signifikanter Teilabschnitt 30 der Kennlinien 20 tritt deutlicher in der ersten Ableitung dV/dSOC in den Figuren 12(b) und 13(b) hervor.

Aus Figur 13(b) wird deutlich, dass mit größerem zeitlichem Abstand, also anwachsender Zeit t in Pfeilrichtung in der Figur 13(b), die Position der Stufe, das heißt der jeweilige Peak 89 in Richtung auf größere SOC-Werte zu verschoben ist, jedoch nicht verschwindet. Dies ist gemäß den obigen Darlegungen ein Hinweis darauf, dass die zu Grunde liegende Batterie 10 durch Verlust an zyklisierbarem Lithium ohne Aufbau von Inhomogenitäten in der Anode altert.

Im Gegensatz dazu wird aus Figur 12(b) dagegen deutlich, dass der Peak 89 bei der abgeleiteten frühesten Kennlinie mit Verstreichen der Zeit t in Pfeilrichtung verschwindet. Dies ist gemäß den obigen Darlegungen ein Hinweis darauf, dass die zu Grunde liegende Batterie 10 auf Grund zyklischer Benutzung mit einem Aufbau von Ladungsinhomogenitäten in der Anode altert.

Diese und weitere Merkmale und Eigenschaften der vorliegenden Erfindung werden an Hand der folgenden Darlegungen weiter erläutert:
Bisherige Verfahren der Zustandserkennung bei einer Batterie ermöglichen nur die Bestimmung des mittleren Ladezustandes der gesamten Batteriezelle. Inhomogene Ladungszustände, wie sie in gealterten Zellen auftreten werden nicht berücksichtigt.

Das Anodenpotential ändert sich über einen großen Ladungsbereich kaum, wodurch Inhomogenitäten sich nicht ausgleichen können. Dadurch kann es an einzelnen Stellen durch partielle lokale Überladung zu einer Metallplattierung und insbesondere zu einer Lithiumplattierung kommen.

Es ist ein Aspekt der vorliegenden Erfindung ein Messverfahren zu schaffen, welches in eine Batteriezustandserkennung integriert werden kann und eine Aussage über Inhomogenitäten im Ladungszustand innerhalb einer Zelle liefert.

Mit dieser Information kann z.B. das Ladeverfahren der Zelle angepasst werden, um eine Schädigung durch eine Lithiumplattierung zu vermeiden.

Erfindung erlaubt also unter anderem die Bestimmung von Inhomogenitäten im Ladungszustand in einer Batteriezelle. Diese Information kann genutzt werden um den Ladeprozess anzupassen, z.B. durch Herabsetzen einer maximalen Ladespannung, durch Herabsetzen eines Ladestroms und dergleichen.

Dies ist wichtig im Hinblick auf zukünftige Schnellladestrategien, weil man dort schneller an Grenzspannungen stößt, welche eine Lithiumplattierung verursachen können.

Erfindungsgemäß können Ladestrategien mit einer Kontrolle des Anodenpotentials versehen werden. Da aber nur das mittlere Anodenpotential aus der Zellspannung bestimmt werden kann, liegt herkömmlicherweise keine Information über lokale Ladungsunterschiede auf der Anode vor.

Mit dem erfindungsgemäßen Verfahren werden diese Unterschiede bestimmt und können in einer Ladestrategie berücksichtigt werden.

## Patentansprüche

1. Verfahren zum Bestimmen eines Alterungszustandes einer Batterie (10), insbesondere einer Lithiumionenbatterie,
mit den Schritten:
(A) Erfassen mindestens eines Abschnittes (25) einer Kennlinie (20) der Batterie (10) zu einem ersten Zeitpunkt (t1),
(B) Festlegen und/oder Bestimmen mindestens eines signifikanten Teilabschnittes (30) oder Punktes (33) in dem Abschnitt (25) der Kennlinie (20) der Batterie (10),
(C) Erfassen des entsprechenden signifikanten Teilabschnittes (30) oder Punktes (33) in dem Abschnitt (25) der Kennlinie (20) der Batterie (10) zu einem zweiten Zeitpunkt (t2) nach dem ersten Zeitpunkt (t1),
(D) Bestimmen eines Veränderungsmaßes des signifikanten Teilabschnittes (30) oder Punktes (33) in dem Abschnitt (25) der Kennlinie (20) der Batterie (10) zu den ersten und zweiten Zeitpunkten (t1, t2), wobei das Veränderungsmaß repräsentativ für ein Maß der Veränderung des signifikanten Teilabschnittes (30) oder Punktes (33) in dem Abschnitt (25) der Kennlinie (20) der Batterie (10) zu den ersten und zweiten Zeitpunkten (t1, t2) ist, und
(E) Erzeugen eines für einen Alterungszustand der Batterie (10) repräsentativen Alterungsmaßes auf der Grundlage des Veränderungsmaßes.

2. Verfahren nach Anspruch 1,
bei welchem
- der erste Zeitpunkt (t1) unmittelbar vor, auf oder unmittelbar nach einem Zeitpunkt eines Beginns eines Betriebes, insbesondere eines Erstbetriebes der Batterie (10) liegt und/oder
- der zweite Zeitpunkt (t2) in oder nach einem Betrieb der Batterie (10) liegt.

3. Verfahren nach einem der vorangehenden Ansprüche,
bei welchem der signifikante Teilabschnitt (30) oder Punkt (33) ein Teil einer Stufe, eines Peaks und/oder Flanke in der Kennlinie (20) der Batterie (10) und/oder in einer - insbesondere durch Differentiation oder Integration gewonnenen - Ableitung der Kennlinie (20) der Batterie (10) ist.

4. Verfahren nach einem der vorangehenden Ansprüche,
bei welchem die Kennlinie (20) der Batterie (10)
- eine Kennlinie einer Vollzelle (15) der Batterie (10), eine Kennlinie einer Anode (11) der Batterie (10) und/oder eine Kennlinie einer Kathode (12) der Batterie (10) aufweist und/oder
- repräsentativ ist für einen Verlauf einer Leerlaufspannung der Batterie (10).

5. Verfahren nach einem der vorangehenden Ansprüche,
bei welchem das Veränderungsmaß repräsentativ ist für eine Änderung (i) einer Position, (ii) einer Ausdehnung, (iii) einer Form und/oder (iv) einer Amplitude des signifikanten Teilabschnittes (30) oder Punktes (33) in dem Abschnitt (25) der Kennlinie (20) der Batterie (10).

6. Verfahren nach einem der vorangehenden Ansprüche,
bei welchem der Schritt (C) des Erfassens des entsprechenden signifikanten Teilabschnittes (30) oder Punktes (33) zum zweiten Zeitpunkt (t2) ein Erfassen einer entsprechenden Kennlinie (20) der Batterie (10) zum zweiten Zeitpunkt (t2) aufweist.

7. Verfahren nach einem der vorangehenden Ansprüche,
bei welchem ein signifikanter Teilabschnitt (30) oder Punkt (33) in einer der Kennlinien der Vollzelle (15), der Anode (11) und der Kathode (12) der Batterie (10) bestimmt und durch Auffinden in mindestens einer anderen der Kennlinien der Vollzelle (15), der Anode (11) und der Kathode (12) verifiziert wird.

8. Verfahren nach einem der vorangehenden Ansprüche,
bei welchem,
(i) wenn eine Verschiebung eines signifikanten Teilabschnittes (30) oder Punktes (33) in der Kennlinie (20) der Batterie (10) und/oder in einer Ableitung der Kennlinie (20) der Batterie (10) ermittelt wird und
(ii) wenn die Verschiebung insbesondere ein vorgegebenes Maß überschreitet,
angezeigt wird, dass die Batterie (10) ohne Inhomogenität im Ladezustand und/oder ohne Metallplattierung an einer der Elektroden (11, 12) und insbesondere der Anode (11) gealtert ist.

9. Verfahren nach einem der vorangehenden Ansprüche,
bei welchem,
(iii) wenn eine Verbreiterung eines signifikanten Teilabschnittes (30) und/oder eine Absenkung der Amplitude eines signifikanten Teilabschnittes (30) oder Punktes (33) in der Kennlinie (20) der Batterie (10) und/oder in einer Ableitung der Kennlinie (20) der Batterie (10) ermittelt wird und
(iv) wenn insbesondere die Verbreiterung und/oder die Absenkung der Amplitude ein vorgegebenes Maß überschreiten und insbesondere der entsprechende signifikante Teilabschnitt (30) oder Punkt (33) in der Kennlinie (20) der Batterie (10) und/oder in einer Ableitung der Kennlinie (20) der Batterie (10) zum zweiten Zeitpunkt (t2) nicht bestimmt werden können,
angezeigt wird, dass die Batterie (10) mit Inhomogenität im Ladezustand und/oder mit Metallplattierung an einer der Elektroden (11, 12) und insbesondere der Anode (11) gealtert ist.

10. Verfahren zum Steuern des Ladens, Entladens und/oder Betriebes einer Batterie (10), insbesondere einer Lithiumionenbatterie,
bei welchem
- der Alterungszustand der Batterie (10) mit einem Verfahren nach einem der Ansprüche 1 bis 9 durch Erzeugen eines Alterungsmaßes der Batterie (10) bestimmt wird und
- eine Laden, ein Entladen und/oder ein Betrieb der Batterie (10) auf der Grundlage des Alterungsmaßes der Batterie (10) gesteuert wird.

11. Betriebsvorrichtung (100), insbesondere Fahrzeug,
mit
- einem Betriebsmittel (101) zum Ausführen eines Betriebsvorganges,
- einer Batterie (10) zum Versorgen des Betriebsmittels (101) mit elektrischer Energie und
- einer Steuereinheit (110) zum Steuern des Betriebsmittels (101) und insbesondere des Versorgens des Betriebsmittels (101) und/oder der Batterie (10) mit elektrischer Energie,
**dadurch gekennzeichnet dass**
die Steuereinheit (110) eingerichtet ist, ein Verfahren nach Anspruch 10 auszuführen.

## Claims

1. Method for determining a state of ageing of a battery (10), in particular a lithium-ion battery, comprising the steps:
(A) detecting at least one section (25) of a characteristic curve (20) of the battery (10) at a first point in time (t1),
(B) establishing and/or determining at least one significant portion (30) or point (33) in the section (25) of the characteristic curve (20) of the battery (10),
(C) detecting the corresponding significant portion (30) or point (33) in the section (25) of the characteristic curve (20) of the battery (10) at a second point in time (t2) after the first point in time (t1),
(D) determining a measure of the change of the significant portion (30) or point (33) in the section (25) of the characteristic curve (20) of the battery (10) at the first and second points in time (t1, t2), wherein the measure of the change is representative of an extent of the change in the significant portion (30) or point (33) in the section (25) of the characteristic curve (20) of the battery (10) at the first and second points in time (t1, t2), and
(E) generating a measure of the ageing that is representative of a state of ageing of the battery (10) on the basis of the measure of the change.

2. Method according to Claim 1,
in which
- the first point in time (t1) lies immediately before, at, or immediately after a point in time at which an operation starts, in particular a first operation of the battery (10) and/or
- the second point in time (t2) lies in or after an operation of the battery (10).

3. Method according to one of the preceding claims,
in which the significant portion (30) or point (33) is part of a step, a peak and/or flank in the characteristic curve (20) of the battery (10) and/or in a derivative of the characteristic curve (20) of the battery (10) - in particular obtained by differentiation or integration.

4. Method according to one of the preceding claims,
in which the characteristic curve (20) of the battery (10)
- includes a characteristic curve of a complete cell (15) of the battery (10), a characteristic curve of an anode (11) of the battery (10) and/or a characteristic curve of a cathode (12) of the battery (10) and/or
- is representative of a course of an open-circuit voltage of the battery (10).

5. Method according to one of the preceding claims,
in which the measure of the change is representative of a change (i) in a position, (ii) extent, (iii) shape and/or (iv) amplitude of the significant portion (30) or point (33) in the section (25) of the characteristic curve (20) of the battery (10).

6. Method according to one of the preceding claims,
in which the step (C) of detecting the corresponding significant portion (30) or point (33) at the second point in time (t2) includes detecting a corresponding characteristic curve (20) of the battery (10) at the second point in time (t2).

7. Method according to one of the preceding claims,
in which a significant portion (30) or point (33) in one of the characteristic curves of the full cell (15), the anode (11) and the cathode (12) of the battery (10) is determined and is verified by searching at least one other of the characteristic curves of the full cell (15), the anode (11) and the cathode (12).

8. Method according to one of the preceding claims,
in which
(i) if a shift in a significant portion (30) or point (33) in the characteristic curve (20) of the battery (10) and/or in a derivative of the characteristic curve (20) of the battery (10) is determined, and
(ii) if the shift in particular exceeds a predefined extent,
it indicates that the battery (10) has aged without any inhomogeneity in the state of charge and/or without any metal plating on one of the electrodes (11, 12) and in particular the anode (11).

9. Method according to one of the preceding claims,
in which
(iii) if a broadening of a significant portion (30) and/or a decrease in the amplitude of a significant portion (30) or point (33) in the characteristic curve (20) of the battery (10) and/or in a derivative of the characteristic curve (20) of the battery (10) is determined and
(iv) if in particular the widening and/or the decrease in the amplitude exceeds a predefined extent and in particular the corresponding significant portion (30) or point (33) in the characteristic curve (20) of the battery (10) and/or in a derivative of the characteristic curve (20) of the battery (10) cannot be determined at the second point in time (t2),
it indicates that the battery (10) has aged with inhomogeneity in the state of charge and/or with metal plating on one of the electrodes (11, 12) and in particular the anode (11).

10. Method for controlling the charging, discharging and/or operation of a battery (10), in particular a lithium ion battery,
in which
- the state of ageing of the battery (10) is determined by using a method according to one of Claims 1 to 9 by producing a measure of the ageing of the battery (10), and
- charging, discharging and/or operating the battery (10) is controlled on the basis of the measure of ageing of the battery (10).

11. Operating device (100), in particular a vehicle, having
- an operating means (101) for carrying out an operating procedure,
- a battery (10) for supplying the operating means (101) with the electrical energy, and
- a control unit (110) for controlling the operating means (101) and in particular the supplying of the operating means (101) and/or the battery (10) with electrical energy,
**characterized in that** the control unit (110) is set up to carry out a method according to Claim 10.

## Revendications

1. Procédé de détermination d'un état de vieillissement d'une batterie (10), notamment d'une batterie au lithium-ion, comprenant les étapes suivantes :
(A) acquisition d'au moins une portion (25) d'une courbe caractéristique (20) de la batterie (10) à un premier instant (t1),
(B) spécification et/ou détermination d'au moins une portion partielle (30) significative ou d'un point (33) significatif dans la portion (25) de la courbe caractéristique (20) de la batterie (10),
(C) acquisition de la portion partielle (30) significative ou du point (33) significatif correspondant dans la portion (25) de la courbe caractéristique (20) de la batterie (10) à un deuxième instant (t2) après le premier instant (t1),
(D) détermination d'une mesure de variation de la portion partielle (30) significative ou du point (33) significatif dans la portion (25) de la courbe caractéristique (20) de la batterie (10) au premier ou au deuxième instant (t1, t2), la mesure de variation étant représentative d'une mesure de la variation de la portion partielle (30) significative ou du point (33) significatif dans la portion (25) de la courbe caractéristique (20) de la batterie (10) au premier et au deuxième instant (t1, t2), et
(E) génération d'une mesure de vieillissement représentative d'un état de vieillissement de la batterie (10) sur la base de la mesure de variation.

2. Procédé selon la revendication 1, avec lequel
- le premier instant (t1) se trouve directement avant, pendant ou directement après un instant d'un début d'un fonctionnement, notamment d'un premier fonctionnement de la batterie (10) et/ou
- le deuxième instant (t2) se trouve dans ou après un fonctionnement de la batterie (10).

3. Procédé selon l'une des revendications précédentes, avec lequel la portion partielle (30) significative ou le point (33) significatif est une partie d'un étage, une crête et/ou un front dans la courbe caractéristique (20) de la batterie (10) et/ou dans une dérivation de la courbe caractéristique (20) de la batterie (10), notamment obtenue par différenciation ou intégration.

4. Procédé selon l'une des revendications précédentes, avec lequel la courbe caractéristique (20) de la batterie (10)
- présente une courbe caractéristique d'une cellule pleine (15) de la batterie (10), une courbe caractéristique d'une anode (11) de la batterie (10) et/ou une courbe caractéristique d'une cathode (12) de la batterie (10) et/ou
- est représentative pour un tracé d'une tension à vide de la batterie (10).

5. Procédé selon l'une des revendications précédentes, avec lequel la mesure de variation est représentative d'une modification (i) d'une position, (ii) d'une dilatation, (iii) d'une forme et/ou (iv) d'une amplitude de la portion partielle (30) significative ou du point (33) significatif dans la portion (25) de la courbe caractéristique (20) de la batterie (10).

6. Procédé selon l'une des revendications précédentes, avec lequel l'étape (C) d'acquisition de la portion partielle (30) significative ou du point (33) significatif correspondant au deuxième instant (t2) présente une acquisition d'une courbe caractéristique (20) correspondante de la batterie (10) au deuxième instant (t2).

7. Procédé selon l'une des revendications précédentes, avec lequel une portion partielle (30) significative ou un point (33) significatif est déterminé(e) dans l'une des courbes caractéristiques de la cellule pleine (15), de l'anode (11) et de la cathode (12) de la batterie (10) et vérifié(e) par recherche dans au moins une autre des courbes caractéristiques de la cellule pleine (15), de l'anode (11) et de la cathode (12).

8. Procédé selon l'une des revendications précédentes, avec lequel
(i) lorsqu'un décalage d'une portion partielle (30) significative ou d'un point (33) significatif est déterminé dans la courbe caractéristique (20) de la batterie (10) et/ou dans une dérivation de la courbe caractéristique (20) de la batterie (10) et
(ii) lorsque le décalage dépasse notamment une mesure prédéfinie,
il est affiché que la batterie (10) a vieilli sans inhomogénéité dans l'état de charge et/ou sans dépôt métallique sur l'une des électrodes (11, 12) et notamment l'anode (11).

9. Procédé selon l'une des revendications précédentes, avec lequel
(iii) lorsqu'un élargissement d'une portion partielle (30) significative et/ou une chute de l'amplitude d'une portion partielle (30) significative ou d'un point (33) significatif est déterminé dans la courbe caractéristique (20) de la batterie (10) et/ou dans une dérivation de la courbe caractéristique (20) de la batterie (10) et
(iv) lorsque notamment l'élargissement et/ou la chute de l'amplitude dépasse une mesure prédéfinie et notamment la portion partielle (30) significative ou le point (33) significatif dans la courbe caractéristique (20) de la batterie (10) et/ou dans une dérivation de la courbe caractéristique (20) de la batterie (10) ne peuvent pas être déterminés au deuxième instant (t2),
il est affiché que la batterie (10) a vieilli avec une inhomogénéité dans l'état de charge et/ou avec un dépôt métallique sur l'une des électrodes (11, 12) et notamment l'anode (11).

10. Procédé de commande de la charge, de la décharge et/ou du fonctionnement d'une batterie (10), notamment d'une batterie au lithium-ion, avec lequel
- l'état de vieillissement de la batterie (10) est déterminé avec un procédé selon l'une des revendications 1 à 9 par génération d'une mesure de vieillissement de la batterie (10) et
- une charge, une décharge et/ou un fonctionnement de la batterie (10) est commandé sur la base de la mesure de vieillissement de la batterie (10).

11. Arrangement fonctionnel (100), notamment véhicule, comprenant
- un moyen fonctionnel (101) destiné à exécuter une opération de fonctionnement,
- une batterie (10) destinée à alimenter le moyen fonctionnel (101) avec de l'énergie électrique et
- une unité de commande (110) destinée à commander le moyen fonctionnel (101) et notamment à alimenter le moyen fonctionnel (101) et/ou la batterie (10) avec de l'énergie électrique,
**caractérisé en ce que**
l'unité de commande (110) est conçue pour mettre en œuvre un procédé selon la revendication 10.
